# EUROPÄISCHE PATENTSCHRIFT

(11) **EP 1 259 989 B1**
(45) Veröffentlichungstag und Bekanntmachung des Hinweises auf die Patenterteilung: **28.10.2009**
(21) Anmeldenummer: 01929217.6
(22) Anmeldetag: 23.02.2001
(51) Int. Cl.: H01L 27/06, H01L 29/78, H01L 29/10, H01L 21/336

(54) **MONOLITHISCH INTEGRIERTES HALBLEITERBAUELEMENT**
MONOLITHICALLY INTEGRATED SEMICONDUCTOR COMPONENT
COMPOSANT SEMI-CONDUCTEUR INTEGRE DE FACON MONOLITHIQUE

(30) Priorität: 24.02.2000 DE 10008545
(43) Veröffentlichungstag der Anmeldung: 27.11.2002
(73) Patentinhaber: ROBERT BOSCH GMBH, 70442 Stuttgart (DE)
(72) Erfinder: PLIKAT, Robert, 71665 Vaihingen (DE)
(86) Internationale Anmeldenummer: PCT/DE2001/000708
(87) Internationale Veröffentlichungsnummer: WO 2001/067515

(56) Entgegenhaltungen:
- DE-A- 3 507 181
- US-A- 4 811 065
- US-A- 5 744 994
- US-A- 5 973 367
- PATENT ABSTRACTS OF JAPAN vol. 018, no. 080 (E-1505), 9. Februar 1994 (1994-02-09) -& JP 05 291507 A (FUJITSU LTD), 5. November 1993 (1993-11-05)

## Beschreibung

Die Erfindung betrifft ein monolithisch integriertes Halbleiterbauelement mit den im Oberbegriff des Anspruchs 1 genannten Merkmalen.

### Stand der Technik

Monolithisch integrierte Halbleiterbauelemente der gattungsgemäßen Art sind bekannt. Diese umfassen beispielsweise einen vertikalen MOS(Metall-Oxid-Silizium)-Transistor, der ein relativ schwach dotiertes Substratgebiet eines ersten Leitfähigkeitstypes und eine höher dotierte Schicht gleichen Leitfähigkeitstypes zur Kontaktierung (Drainanschluss) umfasst. In das Substratgebiet wird wenigstens ein Leitfähigkeitsgebiet entgegengesetzten Leitfähigkeitstypes eingebracht, das jeweils ein weiteres Leitfähigkeitsgebiet des ersten Leitfähigkeitstypes umschließt.

Hierdurch kommt es zur Ausbildung von zwei PN-Übergängen, von denen ein erster PN-Übergang durch einen Sourceanschluss kurzgeschlossen ist. Auf der Substratoberfläche ist eine MOS-Struktur aufgebracht, mittels der das oberflächennahe Gebiet der zweiten Ladungsträgergebiete invertiert werden kann, so dass eine leitfähige Verbindung zwischen Sourceanschluss und Drainanschluss entsteht. Über den Sourceanschluss ist das zweite Ladungsträgergebiet mit dem dritten Ladungsträgergebiet elektrisch leitend verbunden - Kurzschluss des ersten PN-Übergangs - so dass es zur Ausbildung einer parasitären Inversdiode kommt. Diese zwangsläufig ausgebildete, parasitäre Inversdiode kann bei verschiedenen Schaltungsvarianten als Freilaufdiode genutzt werden. Soll mittels des monolithisch integrierten Bauelementes beispielsweise eine induktive Last geschaltet werden, ermöglicht die Freilaufdiode ein Umkommutieren des Stromes. Wird die induktive Last beispielsweise mit einer Brückenschaltung aus wenigstens zwei MOS-Transistoren, die als Pulswechselrichter in Hochsetzstellerschaltung verschaltet sind, angesteuert, wird ein erster MOS-Transistor gepulst angesteuert, so dass die induktive Last sich entweder über die parasitäre Inversdiode des weiteren MOS-Transistors freiläuft oder über den durchgesteuerten zweiten MOS-Transistor nachgeladen wird. Kritisch ist hierbei der Einschaltvorgang des gepulst angesteuerten MOS-Transistors, denn hier tritt der Fall auf, dass die Inversdiode bestromt wird und die Ladung ausgeräumt wird, da der andere MOS-Transistor nicht leitend ist. Hierdurch kommt es zu einem sogenannten Strom-Abrissverhalten, das zu steilen ΔI/Δt-Anstiegen führt. Diese wiederum erzeugen Überspannungen und hochfrequente Oszillationen, die zu unerwünschten Störeinflüssen führen.

Bekannt ist, parallel zu den parasitären Inversdiode Schottky-Dioden zu schalten, die eine geringere Flussspannung aufweisen. Hierdurch bleiben die parasitären Inversdioden inaktiv, so dass keine Speicherladung aus dem Substratgebiet der MOS-Transistoren ausgeräumt werden muss. Aus der EP 0 899 791 A2 ist bekannt, die Schottky-Dioden als parallele Freilaufdioden in das monolithische Bauelement mit zu integrieren, wobei eine zusätzliche Ladungsträgerimplantation zur Barriereneinstellung erforderlich ist. Diese zusätzliche Ladungsträgerimplantation erfordert jedoch einen großen technologischen Aufwand, so dass sich die Prozesskosten erhöhen.

Ein weiteres Bauelement ist in dem Dokument US-A-4 811 065 beschrieben.

### Vorteile der Erfindung

Das monolithisch integrierte Halbleiterbauelement mit den im Anspruch 1 genannten Merkmalen bietet dem gegenüber den Vorteil, dass in einfacher Weise eine den parasitären Inversdioden parallel geschaltete Schottky-Diode realisiert werden kann. Dadurch, dass das erste Ladungsträgergebiet eine weitere Kontaktierung umfasst, wobei diese Kontaktierung je nach Dotierungskonzentration des ersten Ladungsträgergebietes oberflächennah mit einem weiteren oberflächennahen Ladungsträgergebiet höherer Konzentration aufdotiert ist, und mit dem Anodenanschluss der wenigstens einen Schottky-Diode verbunden ist, lässt sich innerhalb des ersten Ladungsträgergebietes eine abschirmende Struktur erzeugen, wenn die zusätzliche Kontaktierung auf ein Potential oberhalb des Potentials des zweiten Ladungsträgergebietes gezogen wird. Hierdurch wird möglich, die sogenannte Schottky-Klammerung bei höher sperrenden MOS-Transistoren zuverlässig auszulegen, wobei ein notwendiger Sicherheitszuschlag der Durchbruchspannung - unter Beachtung der Toleranzen der Flussspannungen - reduziert werden kann und gegebenenfalls außer Acht gelassen werden kann. Durch Reduktion des Sicherheitszuschlages zu der Durchbruchspannung werden aufgrund dieser Sicherheitszuschläge im Durchlassfalle entstehende zusätzliche Spannungsabfälle vermieden. Die Toleranz der Durchbruchspannung hat somit keinen wesentlichen Einfluss auf die Junction-Spannung der parasitären Inversdioden, die bei höher sperrenden MOS-Transistoren auf jedem Fall unter 650 mV bleiben muss, um den Vorwärtsbetrieb der parasitären Inversdioden zu vermeiden.

Die zur Umsetzung der Erfindung lediglich vorzusehende zusätzliche Kontaktierung des ersten Ladungsträgergebietes lässt sich in einfacher Weise durch eine geringe Prozessmodifikation bei der Herstellung des monolithisch integrierten Halbleiterbauelementes erreichen, indem bei der Abscheidung der Metallisierungen für die Kontaktierungen der Sourceanschlüsse gleichzeitig wenigstens eine zusätzliche Maskenöffnung für die zusätzliche Kontaktierung vorgesehen wird. Somit sind zusätzliche Prozessschritte nicht erforderlich. Lediglich eine Änderung des Layouts der Maskierungsebene für die Herstellung der Metallisierungen ist erforderlich.

Durch die über die zusätzliche Kontaktierung in die Schaltungsanordnung einbindbare Schottky-Diode ergibt sich ferner eine Reduktion der Verlustleistung im Sperrfall beziehungsweise Durchlassfall der Schottky-Diode. Durch die unterhalb der zusätzlichen Kontaktierung im ersten Ladungsträgergebiet entstehende Abschirmstruktur fällt über die Schottky-Diode nur eine verhältnismäßig kleine Sperrspannung ab, so dass die für Schottky-Dioden typischerweise sehr hohen Sperrströme deutlich reduziert oder im Gegenzug eine geringere Flussspannung realisiert werden können.

Ferner ist von Vorteil, dass eine einfache Anpassung der Schottky-Dioden an das monolithisch integrierte Halbleiterbauelement erfolgen kann. Die extern an die zusätzliche Kontaktierung angeschlossene Schottky-Diode kann beispielsweise hinsichtlich veränderter Sperrspannungsanforderungen oder thermischer Anforderungen ausgewählt werden. Schließlich kann durch die nunmehr in einfacher Weise mögliche räumliche getrennte Anordnung der Schottky-Diode zu der MOS-Transistorstruktur die zusätzliche Verlustleistung der Schottky-Diode in Bereichen umgesetzt werden, in denen sie nicht zur Aufheizung des monolithisch integrierten Bauelementes beiträgt. Die in einfacher Weise vorgesehene externe Anwendung der Schottky-Dioden bietet darüber hinaus den Vorteil, dass bei Parallelschaltungen von MOS-Transistorstrukturen nicht jeder Transistorstruktur eine eigene Schottky-Diode zugeordnet werden muss, sondern für mehrere Transistorstrukturen eine gemeinsame Schottky-Diode geschaltet werden kann.

Weitere bevorzugte Ausgestaltungen der Erfindung ergeben sich aus den übrigen, in den Unteransprüchen genannten Merkmalen.

### Zeichnungen

Die Erfindung wird nachfolgend in Ausführungsbeispielen anhand der zugehörigen Zeichnungen näher erläutert. Es zeigen:
- Figuren 1 bis 3: schematische Schnittansichten erfindungs- gemäßer monolithisch integrierter Bau- elemente und
- Figuren 4 bis 9: verschiedene Layoutvarianten des erfin- dungsgemäßen Halbleiterbauelementes.

### Beschreibung der Ausführungsbeispiele

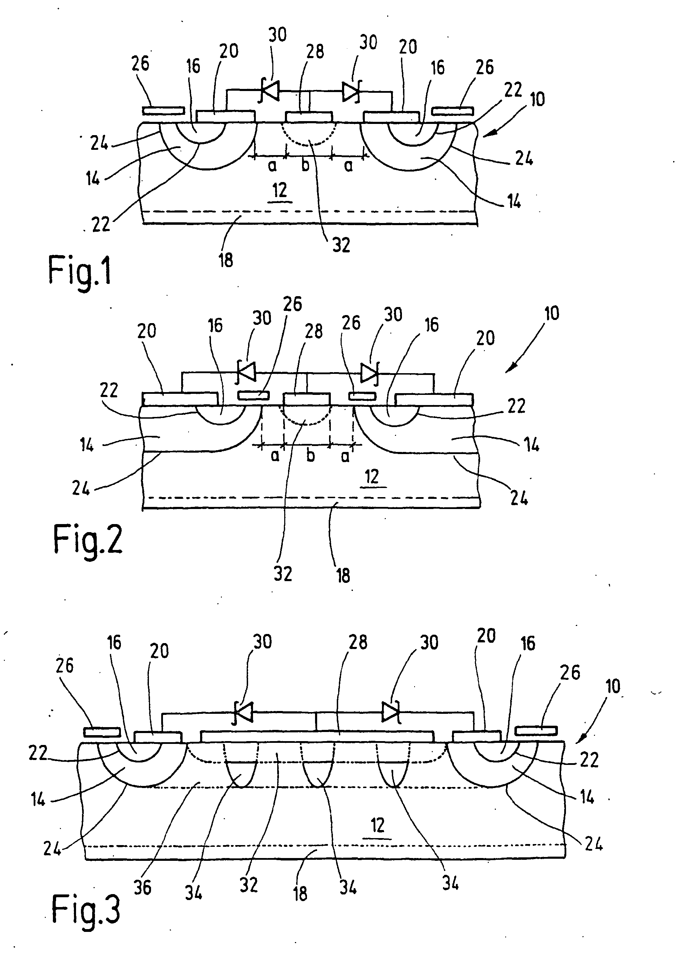

Figur 1 zeigt ein monolithisch integriertes Halbleiterbauelement 10, das als MOS-Feldeffekttransistor ausgebildet ist. Das Halbleiterbauelement 10 umfasst ein Driftgebiet 12, mit einer ersten Ladungsträgerdotierung (p-dotiert). In das Driftgebiet 12 sind Ladungsträgergebiete 14 mit einer zum ersten Ladungsträgergebiet (Driftgebiet) 12 entgegengesetzten Ladungsträgerdotierung (n-dotiert) eingebracht. In die Ladungsträgergebiete 14 sind weitere Ladungsträgergebiete 16 integriert. Die Ladungsträgergebiete 16 besitzen die gleiche Ladungsträgerdotierung wie das Ladungsträgergebiet 12, sind jedoch höher dotiert (p⁺-dotiert). Das Ladungsträgergebiet 12 ist auf einer Schicht 18 angeordnet, die die gleiche Ladungsträgerdotierung wie das Ladungsträgergebiet 12 besitzt jedoch höher dotiert (p⁺-dotiert) ist. Auf der Oberfläche des Halbleiterbauelementes 10 sind Metallisierungen 20 strukturiert, die die Ladungsträgergebiete 14 und 16 im Bereich von deren PN-Übergang 22 kurzschließen. Oberhalb der PN-Übergänge 24 zwischen den Ladungsträgergebieten 14 und 12 ist über ein nicht dargestelltes Oxid eine weitere Metallisierung (Kontaktierung) 26 angeordnet. Die Metallisierung 26 erstreckt sich hierbei auf das gesamte Kanalgebiet.

Das Ladungsträgergebiet 12 ist mit Hilfe eines hochdotierten Gebietes des ersten Leitfähigkeittyps (p⁺-dotiert) mit einer weiteren Metallisierung (Kontaktierung) 28 versehen, die sich zwischen benachbarten PN-Übergängen 24 befindet. Ein Abstand a zwischen der Metallisierung 28 und den PN-Übergängen 24 ist hierbei jeweils gleich. Die Metallisierung 28 ist mit den Metallisierungen 20 über externe Schottky-Dioden 30 verbunden, wobei die Metallisierung 28 jeweils mit den Anoden der Schottky-Dioden 30 verbunden ist.

Die Metallisierung 20 bildet den Sourceanschluss, die Schicht 18 den Drainanschluss und die Metallisierung 26 den Gateanschluss des MOS-Transistors aus. Bei anliegender Steuerspannung am Gateanschluss 26 bilden sich in den Ladungsträgergebieten 14 oberflächennahe Leitungskanäle aus, so dass der Sourceanschluss .20 mit dem Drainanschluss 18 elektrisch leitend verbunden ist und der MOS-Transistor durchsteuert.

Durch den Gesamtabstand a + b + a der Ladungsträgergebiete 14 lässt sich definieren, ab welcher Sperrspannung über den PN-Übergang 24 ein oberflächennaher, zur Kontaktierung höher dotierter Bereich 32 des Ladungsträgergebietes 12 auf einem festen Spannungspotential verbleibt, das unabhängig von einem weiteren Anstieg der Drainspannung ist. Das Spannungspotential im Gebiet 32 ist somit auf eine geometrieabhängige Konstante (a + b + a) beschränkt. Somit können die über die Metallisierung 28 kontaktierten Schottky-Dioden 30 für eine relativ geringe Sperrspannung ausgelegt werden, die durch das Spannungspotential im Gebiet 32 bestimmt ist. Das Gebiet 32 bildet somit eine Abschirmstruktur für die elektrische Anwendung der Schottky-Dioden 30 aus, die zu der erwähnten Begrenzung der Sperrspannung führt. Hierdurch kommt es gleichzeitig zu einer Reduktion der Sperrströme und der Verlustleistung der Schottky-Dioden 30. Die Schottky-Dioden 30 können - in an sich bekannter Weise - als Freilaufdioden, beispielsweise bei der eingangs erwähnten Brückenschaltung zum Schalten induktiver Lasten, eingesetzt werden.

Figur 2 zeigt eine abgewandelte Ausführungsform, wobei gleiche Teile wie in Figur 1 mit gleichen Bezugszeichen versehen und nicht nochmals erläutert sind. Im Unterschied zur Ausführungsvariante in Figur 1, bei der ein sourceseitiger Drainkontakt realisiert ist, ist in Figur 2 ein kanalseitiger (Leitungskanal durch Ladungsträgergebiete 14 bei Ansteuerung der Metallisierungen 26) Drainkontakt realisiert. Hinsichtlich der Funktion wird auf die Beschreibung zu Figur 1 verwiesen.

Figur 3 zeigt eine Ausführungsvariante, bei der zwischen den Ladungsträgergebieten 14 vergrabene Ladungsträgergebiete 34 angeordnet sind, die die gleiche Ladungsträgerdotierung wie die Ladungsträgergebiete 14 umfassen. Die Ladungsträgergebiete 34 sind in einer Gitterstruktur angeordnet, wodurch es zwischen den Ladungsträgergebieten 14 zu hier angedeuteten leitfähigen Verbindungen 36 kommt. Durch die vergrabenen Strukturen 34 und die leitfähigen Verbindungen 36 kommt es zur Ausbildung einer an sich bekannten JFET-Struktur, die hier eine Abschirmstruktur des Gebietes 32 übernimmt. Somit ist ein Potentialanstieg im Gebiet 32 ebenfalls begrenzt, was zu der erwähnten Reduzierung der notwendigen Sperrspannung der Schottky-Dioden 30 führt.

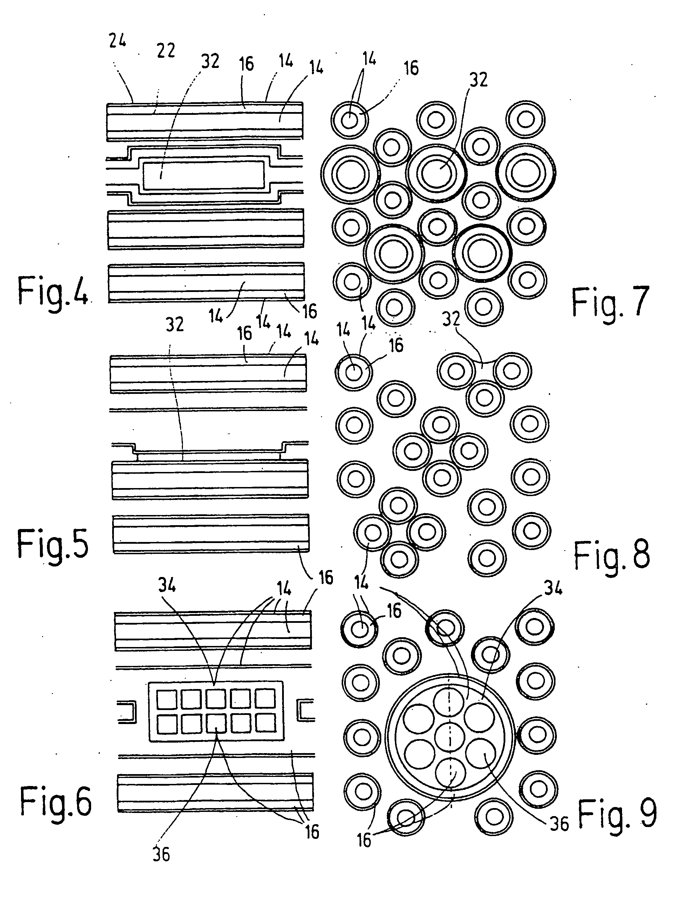

In den Figuren 4 bis 9 sind verschiedene Layoutvarianten des Bauelementes 10 schematisch in Draufsicht gezeigt. Bei den Figuren 4 bis 6 handelt es sich um ein sogenanntes Streifendesign, während es sich bei den Figuren 7 bis 9 um ein sogenanntes Zellendesign handelt. Die einzelnen Dotierungsgebiete sind mit den in den Figuren 1 bis 3 erläuterten Bezugszeichen versehen, so dass hinsichtlich der Anordnung auf diese Figuren verwiesen wird.

Die Figuren 4 und 7 entsprechen hierbei der Figur 1, die Figuren 5 und 8 der Figur 2 und die Figuren 6 und 9 der Figur 3.

## Patentansprüche

1. Monolithisch integriertes Halbleiterbauelement, mit einem ersten Ladungsträgergebiet (12) einer ersten p-dotierten Ladungsträgerdotierung, wenigstens zwei innerhalb des ersten Ladungsträgergebietes (12) beabstandet zueinander strukturierten zweiten Ladungsträgergebieten (14) mit entgegengesetzter Ladungsträgerdotierung und innerhalb der zweiten Ladungsträgergebiete (14) strukturierten dritten Ladungsträgerbiete (16) mit der ersten Ladungsträgerdotierung, wobei ein PN-Übergang (22) zwis-chen den zweiten Ladungsträgergebieten (14) und den dritten Ladungsträgergebieten (16) über eine Kontaktierung (20), die den Sourceanschluss bildet, kurzgeschlossen iss, das erste Ladungsträgergebiet (12) mit einem Kontakt (18), der den Drainanschluss bildet, versehen ist und die zweiten Ladungsträgergebiete (14) mittels einer Kontaktierung (26), die den Gateanschluss bildet, im Bereich zwischen dem ersten Ladungsträgergebiet (12) und dem dritten Ladungsträgergebiet (16) invertierbar sind, und wenigstens einer parallel zum ersten Ladungsträgergebiet (12) und dritten Ladungsträgergebiet (16) geschalteten Schottky-Diode (30), **dadurch gekennzeichnet, dass** auf das erste Ladungsträgergebiet (12) eine weitere Kontaktierung (28) aufgebracht ist und dieser Kontaktierung (28) ein weiteres Ladungsträgergebiet (32) zugeordnet ist, das gegenüber der Dotierungskonzentration des ersten Gebietes (12) höher aufdotiert ist, wodurch ein Ohm'scher Kontakt entsteht und dieser mit dem Anodenanschluss der wenigstens einen externen Schottky-Diode (30) verbunden ist.

2. Halbleiterbauelement nach Anspruch 1, **dadurch gekennzeichnet, dass** die Kontaktierung (28) im Bereich einer sich bei anliegender Drainspannung einstellenden Abschirmstruktur (32) angeordnet ist.

3. Halbleiterbauelement nach einem der vorhergehenden Ansprüche, **dadurch gekennzeichnet, dass** die Abschirmstruktur (32) durch einen Abstand (a + b + a) von PN-Übergängen (24) benachbarter zweiter Ladungsträgergebiete (14) definiert ist.

4. Halbleiterbauelement nach einem der vorhergehenden Ansprüche, **dadurch gekennzeichnet, dass** das Halbleiterbauelement (10) eine sourceseitigen Drainkontakt (18) aufweist.

5. Halbleiterbauelement nach einem der Ansprüche 1 bis 3, **dadurch gekennzeichnet, dass** das Halbleiterbauelement (10) eine kanalseitigen Drainkontakt (18) aufweist.

6. Halbleiterbauelement nach einem der vorhergehenden Ansprüche, **dadurch gekennzeichnet, dass** die Abschirmstruktur (32) durch eine vergrabene JFET-Struktur (34; 36) definiert ist.

## Claims

1. Monolithically integrated semiconductor component, comprising a first charge carrier region (12) having a first, p-doped charge carrier doping, at least two second charge carrier regions (14) having the opposite charge carrier doping, said at least two second charge carrier regions being structured in a manner spaced apart from one another within the first charge carrier region (12), and third charge carrier regions (16) having the first charge carrier doping, said third charge carrier region being structured within the second charge carrier regions (14), wherein a PN junction (22) between the second charge carrier regions (14) and the third charge carrier regions (16) is short-circuited via a contact-connection (20) forming the source terminal, the first charge carrier region (12) is provided with a contact (18) forming the drain terminal, and the second charge carrier regions (14) can be inverted by means of a contact-connection (26) forming the gate terminal in the region between the first charge carrier region (12) and the third charge carrier region (16), and at least one Schottky diode (30) connected in parallel with the first charge carrier region (12) and third charge carrier region (16), **characterized in that** a further contact-connection (28) is applied to the first charge carrier region (12) and said contact-connection (28) is assigned a further charge carrier region (32), which is doped more highly than the doping concentration of the first region (12), whereby an ohmic contact arises and the latter is connected to the anode terminal of the at least one external Schottky diode (30).

2. Semiconductor component according to Claim 1, **characterized in that** the contact-connection (28) is arranged in the region of a screening structure (32) established when drain voltage is present.

3. Semiconductor component according to any of the preceding claims, **characterized in that** the screening structure (32) is defined by a distance (a + b + a) between PN junctions (24) of adjacent second charge carrier regions (14).

4. Semiconductor component according to any of the preceding claims, **characterized in that** the semiconductor component (10) has a source-side drain contact (18).

5. Semiconductor component according to any of Claims 1 to 3, **characterized in that** the semiconductor component (10) has a channel-side drain contact (18).

6. Semiconductor component according to any of the preceding claims, **characterized in that** the screening structure (32) is defined by a buried JFET structure (34, 36).

## Revendications

1. Composant semi-conducteur monolithique intégré, qui présente :
un premier domaine (12) de porteurs de charges qui présente un premier dopage p en porteurs de charges, au moins deux deuxièmes domaines (14) de porteurs de charges structurés à distance l'un de l'autre à l'intérieur du premier domaine (12) de porteurs de charges et dopé en porteurs de charge de signe opposé ainsi que des troisièmes domaines (16) de porteurs de charges structurés à l'intérieur des deuxièmes domaines (14) de porteurs de charge et présentant le premier dopage en porteurs de charges,
une transition PN (22) entre les deuxièmes domaines (14) de porteurs de charges et les troisièmes domaines (16) de porteurs de charge étant mise en court-circuit par un contact (20) qui forme la borne de raccordement de source,
le premier domaine (12) de porteurs de charge étant doté d'un contact (18) qui forme la borne de raccordement de drain et les deuxièmes domaines (14) de porteurs de charges pouvant être inversés au moyen d'un contact (26) qui forme la borne de raccordement de grille dans la zone située entre le premier domaine (12) de porteurs de charge et le troisième domaine (16) de porteurs de charge,
au moins une diode Schottky (30) raccordée en parallèle par rapport au premier domaine (12) de porteurs de charges et au troisième domaine (16) de porteurs de charges,
**caractérisé en ce que**
un autre contact (28) est appliqué sur le premier domaine (12) de porteurs de charges et un autre domaine (32) de porteurs de charge dopé de manière plus élevée que la concentration de dopage du premier domaine (12) est associé à ce contact (28), ce qui établit un contact ohmique relié à la borne de raccordement d'anode de la ou des diodes Schottky (30) externes.

2. Composant semi-conducteur selon la revendication 1, **caractérisé en ce que** le contact (28) est disposé dans la zone occupée par une structure de blindage (32) qui se forme lorsqu'une tension est appliquée sur le drain.

3. Composant semi-conducteur selon l'une des revendications précédentes, **caractérisé en ce que** la structure de blindage (32) est définie par une distance (a + b + a) entre les transitions PN (24) de deuxièmes domaines (14) de porteurs de charges voisins.

4. Composant semi-conducteur selon l'une des revendications précédentes, **caractérisé en ce que** du côté de la source, le composant semi-conducteur (10) présente un contact (18) avec le drain.

5. Composant semi-conducteur selon l'une des revendications 1 à 3, **caractérisé en ce que** du côté du canal, le composant semi-conducteur (10) présente un contact (18) avec le drain.

6. Composant semi-conducteur selon l'une des revendications précédentes, **caractérisé en ce que** la structure de blindage (32) est définie par une structure JFET (34, 36) en fossé.
